# EUROPEAN PATENT SPECIFICATION

(11) **EP 2 145 199 B1**
(45) Date of publication and mention of the grant of the patent: **12.12.2018**
(21) Application number: 08737949.1
(22) Date of filing: 22.04.2008
(51) Int. Cl.: G01R 33/561

(54) **MAGNETIC RESONANCE DEVICE AND METHOD FOR PROPELLER MRI**
MAGNETRESONANZGERÄT UND VERFAHREN FÜR PROPELLER-MRI
DISPOSITIF À RÉSONANCE MAGNÉTIQUE ET PROCÉDÉ D'IRM PROPELLER

(30) Priority: 27.04.2007 EP 07107078
(43) Date of publication of application: 20.01.2010
(60) Divisional application: 14172087.0
(73) Proprietor: Koninklijke Philips N.V., 5656 AE Eindhoven (NL); Philips Intellectual Property & Standards GmbH, 20099 Hamburg (DE)
(72) Inventor: EGGERS, Holger, NL-5656 AE Eindhoven (NL); NEHRKE, Kay, NL-5656 AE Eindhoven (NL); BOERNERT, Peter, NL-5656 AE Eindhoven (NL)
(74) Representative: van Velzen, Maaike Mathilde
(86) International application number: PCT/IB2008/051544
(87) International publication number: WO 2008/132659

(56) References cited:
- US-A- 5 754 046
- US-A1- 2007 001 672
- NEHRKE K ET AL: "Golden angle PROPELLER MRI" PROCEEDINGS OF THE JOINT ANNUAL MEETING ISMRM-ESMRMB, BERLIN, GERMANY, 19-25 MAY 2007, 19 May 2007 (2007-05-19), page 1729, XP002494269
- CHUANG T-C ET AL: "Data-sharing PROPELLER imaging for increased temporal resolution retaining spatial resolution and image contrast" PROCEEDINGS OF THE INTERNATIONAL SOCIETY FOR MAGNETIC RESONANCE IN MEDICINE, ISMRM 14TH SCIENTIFIC MEETING AND EXHIBITION, 6-12 MAY 2006, SEATTLE, USA, 6 May 2006 (2006-05-06), page 2954, XP002494270
- XIUQUAN JI ET AL: "An improved mri method for dynamic contrast-enhanced imaging of tumors" PROCEEDINGS OF THE 25TH. ANNUAL INTERNATIONAL CONFERENCE OF THE IEEE ENGINEERING IN MEDICINE AND BIOLOGY SOCIETY. CANCUN, MEXICO, SEPT. 17 20030917; 20030917 - 20030921 NEW YORK, NY : IEEE, US, vol. 1, 17 September 2003 (2003-09-17), pages 478-481, XP010693297 ISBN: 978-0-7803-7789-9
- MACLAREN JR ET AL: "TRELLIS MRI: A novel approach to motion correction" PROCEEDINGS OF THE INTERNATIONAL SOCIETY FOR MAGNETIC RESONANCE IN MEDICINE, ISMRM 14TH SCIENTIFIC MEETING AND EXHIBITION, 6-12 MAY 2006, SEATTLE, USA, 6 May 2006 (2006-05-06), page 3194, XP002494271
- PIPE J G: "Motion correction with PROPELLER MRI: application to head motion and free-breathing cardiac imaging" MAGNETIC RESONANCE IN MEDICINE, ACADEMIC PRESS, DULUTH, MN, US, vol. 42, no. 5, 1 November 1999 (1999-11-01), pages 963-969, XP002207261 ISSN: 0740-3194
- STEFANIE WINKELMANN ET AL: "An Optimal Radial Profile Order Based on the Golden Ratio for Time-Resolved MRI" IEEE TRANSACTIONS ON MEDICAL IMAGING, IEEE SERVICE CENTER, PISCATAWAY, NJ, US, vol. 26, no. 1, 1 January 2007 (2007-01-01), pages 68-76, XP011152669 ISSN: 0278-0062
- ARFANAKIS K ET AL: "k-space undersampling in PROPELLER imaging" MAGNETIC RESONANCE IN MEDICINE, 2005, pages 675-683, XP002494272
- PIPE JG: "Improved in-plane motion correction for PROPELLER MRI" PROCEEDINGS OF THE INTERNATIONAL SOCIETY FOR MAGNETIC RESONANCE IN MEDICINE, 9TH SCIENTIFIC MEETING AND EXHIBITION, GLASGOW, SCOTLAND, UK, 21-27 APRIL 2001, 21 April 2001 (2001-04-21), page 743, XP002502663
- YANQIU FENG ET AL: "New Algorithm for Extracting Motion Information from PROPELLER Data and Head Motion Correction in T1-Weighted MRI" ENGINEERING IN MEDICINE AND BIOLOGY SOCIETY, 2005. IEEE-EMBS 2005. 27T H ANNUAL INTERNATIONAL CONFERENCE OF THE SHANGHAI, CHINA 01-04 SEPT. 2005, PISCATAWAY, NJ, USA,IEEE, 1 September 2005 (2005-09-01), pages 1378-1381, XP010908032 ISBN: 978-0-7803-8741-6

## Description

### FIELD OF THE INVENTION

The invention relates to a device for magnetic resonance imaging (MRI) of a body placed in an examination volume.

Furthermore, the invention relates to a method for MRI and to a computer program for a magnetic resonance (MR) device.

### DESCRIPTION OF THE PRIOR ART

In MRI, pulse sequences consisting of RF pulses and switched magnetic field gradients are applied to an object (a patient) placed in a homogeneous magnetic field within an examination volume of an MR device. In this way, MR signals are generated, which are scanned by means of radio frequency (RF) receiving antennas in order to obtain information about the object and to reconstruct images thereof. Since its initial development, the number of clinically relevant fields of application of MRI has grown enormously. MRI can be applied to almost every part of the body, and it can be used to obtain important functional information about the human body. The pulse sequence, which is applied during an MRI scan, plays a significant role in the determination of the characteristics of the reconstructed image, such as location and orientation in the object, dimensions, resolution, signal-to-noise ratio, contrast, sensitivity for movements, et cetera. An operator of an MRI device has to choose the appropriate sequence and has to adjust and optimize its parameters for the respective application.

In the known so-called PROPELLER concept (Periodically Rotated Overlapping ParalEL Lines with Enhanced Reconstruction, see James G. Pipe: "Motion Correction With PROPELLER MRI: Application to Head Motion and Free-Breathing Cardiac Imaging", Magnetic Resonance in Medicine, vol. 42, 1999, pages 963-969), MR signals are acquired in k-space in *N* strips, each consisting of *L* parallel lines, corresponding to the *L* lowest frequency phase-encoding lines in a Cartesian k-space sampling scheme. Each strip, which is also referred to as k-space blade, is rotated in k-space by an angle δϕ = 180° / *N*, so that the total MR data set spans approximately a circle in k-space. If a data matrix having a diameter *M* is desired, then *L* and *N* are, for instance, chosen so that *L* · *N* = *M* · *π* / 2. One essential characteristic of PROPELLER is that a central circular portion in k-space, having a diameter *L*, is acquired for each k-space blade. This central portion can be used to reconstruct a low-resolution image for each k-space blade. These low-resolution images, or their k-space representations, are compared to each other to remove in-plane displacements and phase errors, which are due to patient motion. In addition, a suitable technique such as cross-correlation is employed to determine which k-space blades were acquired with significant through-plane displacement. As the MR signals are combined in k-space before the reconstruction of the final MR image, the MR data from k-space blades with the least amount of through-plane motion are preferentially used in regions in which the k-space blades overlap, so that artifacts arising from through-plane motion are reduced. The PROPELLER technique makes use of oversampling in the central portion of k-space in order to obtain an MR image acquisition technique that is robust with respect to motion of the examined patient during MR signal acquisition.

Chuang et al. (Proc. ISMRM, p. 295, 2006) propose a technique referred to as data-sharing PROPELLER which combines k-space blades with different contrast using the well-known 'keyhole'-concept for dynamic MRI.

Ji et al. (IEEE EMBS, p. 478-481, 2003) describe an improved MRI approach for dynamic contrast-enhanced imaging of tumors. In this approach, a new data acquisition scheme is employed which is principally based on PROPELLER. The k-space blades are rotated in a special order so that two consecutively acquired blades cover k-space in orthogonal directions.

In the article "TRELLIS MRI: A Novel Approach to Motion Correction " by MacLaren et al. (Proc. ISMRM, p. 3194, 2006) motion information is gained for corresponding motion correction by filling k-space using interleaved horizontal and vertical strips. The phase and frequency encoding directions are alternated so that the frequency encoding direction is always paralleling each strip. The motion of the imaged object is deduced after the acquisition of each strip. The corresponding motion correction is then performed by rotating each strip back to a fixed reference position and by appropriate phase-adjustment.

US 2007/0001672 A1 discloses a PROPELLER-based MRI method, wherein a high-pass convolution of each acquired k-space blade with a reference k-space blade is determined and converted to a δ function. In-plane motion of the imaged object during data acquisition is deduced from the δ function.

Pipe et al. (Proc. ISMRM, p. 743, 2001) likewise propose an improved in-plane motion correction scheme for PROPELLER MRI. Therein, a single k-space blade is initially chosen as a reference blade. All other acquired k-space blades are translated to the location of the reference blade and an averaged image is calculated. In a second iteration, all k-space blades are translated to match the averaged image.

Arfanakis et al. (Magn. Reson. Med., p. 675-683, 2005) propose to reduce the scan time for PROPELLER MRI by means of undersampling. Undersampling is performed by removing whole k-space blades from a conventional PROPELLER sampling scheme, by using asymmetric k-space blades and by taking advantage of Hermitian symmetries to fill-in missing data. Imaging time is significantly reduced in this way without causing image artifacts.

### SUMMARY OF THE INVENTION

One problem of the known PROPELLER concept is that a complete rejection of motion-corrupted k-space blades results in undersampling of the peripheral k-space regions and, hence, in a potentially degraded image quality.

Another problem associated with multi-slice PROPELLER imaging is that individual slices from a multi-slice PROPELLER acquisition may be misaligned. The reason for this is that PROPELLER cross-correlates repeatedly measured MR signals in the central k-space as a reference for motion correction. Typically a reference is chosen showing the most similarity to the central k-space data of the other blades. The reference data chosen in accordance with PROPELLER is thus not an absolute but a relative reference, which may cause misalignment of the individual slices. A retrospective alignment of the slices of a multi-slice MR scan is possible in principle, provided that adjacent slices show substantial similarity. This pre-requisite is questionable in general, however.

For an accurate MR image reconstruction, the known PROPELLER imaging method requires a weighting of the acquired k-space samples. This is usually referred to as sampling density compensation. To compute the weighting factors, an iterative approach is commonly taken. The weighting also permits a prioritization of MR signals according to various criteria, such as correlation measures of the cross-correlated k-space blades, in order to achieve the above-mentioned reduction of motion-induced image artifacts. This prioritization can be applied in k-space areas that are more densely sampled than actually required to support the selected field of view. A drawback of the known technique is that the usually taken iterative approach for computing the weighting factors is slow and sporadically instable, especially if a strong contrast weighting is applied

Therefore, it is readily appreciated that there is a need for an improvement of the known PROPELLER imaging concept. It is consequently an object of the invention to provide an MR device that enables a reduction of image artifacts and an improved efficiency with PROPELLER imaging.

In accordance with the present invention, an MR device for MRI of a body placed in an examination volume is disclosed, which comprises means for establishing a substantially homogeneous main magnetic field in the examination volume, means for generating switched magnetic field gradients superimposed upon the main magnetic field, means for radiating RF pulses towards the body, control means for controlling the generation of the magnetic field gradients and the RF pulses, means for receiving and sampling MR signals, and reconstruction means for forming MR images from the signal samples. The invention proposes that the MR device is arranged to
a) generate a series of MR signals by subjecting at least a portion of the body to an MR imaging sequence of at least one RF pulse and switched magnetic field gradients,
b) acquire a plurality of k-space blades according to the PROPELLER scheme, the k-space blades being rotated about a center of k-space, wherein the rotation angle of consecutively acquired k-space blades is incremented during MR signal acquisition by an angle being approximately equal to the golden angle of 137,51° or to the half golden angle of 68,75°, and
c) reconstruct an MR image from the acquired MR signals.

The invention is based on the recognition of the fact that a regular angular undersampling produces only minimal image artifacts. Hence, the least artifacts can be expected if, in accordance with the invention, motion-corrupted k-space blades are distributed as uniformly as possible over the circle spanned by the rotated k-space blades. Since the angle is incremented according to the invention by an angle being approximately equal to golden angle or the half golden angle, an interleaved arrangement of successively acquired k-space blades is achieved. The regular angular undersampling proposed by the invention is more robust for image reconstruction than the omission of several motion-corrupted adjacent k-space blades which is characteristic for the conventional linear order of blades. According to the invention, the so-called Golden Angle principle is applied to PROPELLER MRI to generate an interleaved spatiotemporal order of k-space blades. The Golden Angle is the angle created by dividing the circumference *c* of a circle into two sections *a* and *b*, such that *c* = *a* + *b* and *c* / *a* = *a* / *b*. The Golden Angle principle applied to PROPELLER MRI according to the invention enables a particularly isotropic distribution of corrupted k-space blades over the circle spanned by the rotated blades and, thus, a minimization of motion-induced artifacts in the finally reconstructed MR image. By incrementing the rotation angle by the Golden Angle an isotropic, increasingly dense angular coverage of the circle is achieved. For the diametric PROPELLER blades, only a semicircle has to be considered, which results in a rotation increment of the half Golden Angle.

In a practical embodiment of the invention, the rotation angle of the k-space blades is selected according to the formula ϕ(*i*) = *f*(*i*)·180° / *N* or *ϕ*(*i*) = *f*(*i*)·*180*°·(*1* + *1* / *N*), wherein *i* = 1,2,...*N* represents an index of the consecutively acquired k-space blades, and *f*(*i*) represents a function that maps the index *i* to an integral number between 0 and *N -* 1 such that the rotation angle increment *ϕ*(*i* + 1) - *ϕ*(*i*) is approximately equal to the golden angle or to the half golden angle and larger than 180° / *N*. As a consequence of the infinite sequence period resulting from the Golden Angle increment, the blade arrangement within the circle spanned by the k-space blades is slightly asymmetric. However, in a typical PROPELLER acquisition, the number of k-space blades is fixed, making a symmetric arrangement of blades more preferable. This can be achieved by the above formula. The function *f*(*i*) is chosen such that the above-described interleaved arrangement results, wherein the angles *ϕ*(*i*) approximate the Golden Angle (or the half Golden Angle) as closely as possible. In case the formula *ϕ*(*i*) = *f*(*i*)·180° / *N* applies, the readout gradient rotates about 180° during one acquisition. If the rotation angle is determined by the formula *ϕ*(*i*) = *f*(*i*)·*180*°·(*1* + *1* / *N*), the readout gradient rotates about 360° during each acquisition.

The invention not only relates to a device but also to a method for MRI of at least a portion of a body placed in an examination volume of an MR device.

A computer program adapted for carrying out the imaging procedure of the invention can advantageously be implemented on any common computer hardware, which is presently in clinical use for the control of magnetic resonance scanners. The computer program can be provided on suitable data carriers, such as CD-ROM or diskette. Alternatively, it can also be downloaded by a user from an Internet server.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings
Fig. 1 shows an MR scanner according to the invention;
Fig. 2 illustrates the k-space sampling scheme of PROPELLER MRI including the Golden Angle rotation of PROPELLER blades.

### DETAILED DESCRIPTION OF THE EMBODIMENTS

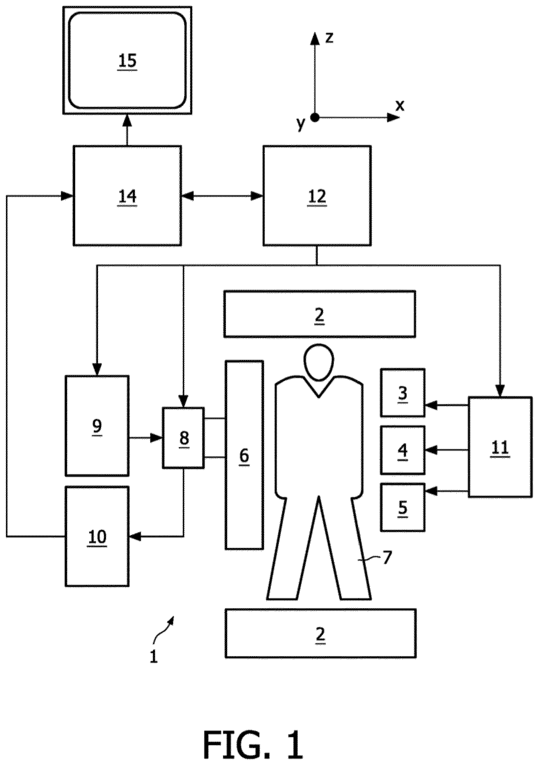

In Fig.1 an MR imaging device 1 in accordance with the present invention is shown as a block diagram. The apparatus 1 comprises a set of main magnetic coils 2 for generating a stationary and homogeneous main magnetic field and three sets of gradient coils 3, 4 and 5 for superimposing additional magnetic fields with controllable strength and having a gradient in a selected direction. Conventionally, the direction of the main magnetic field is labelled the z-direction, the two directions perpendicular thereto the x- and y-directions. The gradient coils 3, 4 and 5 are energized via a power supply 11. The imaging device 1 further comprises an RF transmit antenna 6 for emitting RF pulses to a body 7. The antenna 6 is coupled to a modulator 9 for generating and modulating the RF pulses. Also provided is a receiver for receiving the MR signals, the receiver can be identical to the transmit antenna 6 or be separate. If the transmit antenna 6 and receiver are physically the same antenna as shown in Fig. 1, a send-receive switch 8 is arranged to separate the received signals from the pulses to be emitted. The received MR signals are input to a demodulator 10. The send-receive switch 8, the modulator 9, and the power supply 11 for the gradient coils 3, 4 and 5 are controlled by a control system 12. Control system 12 controls the phases and amplitudes of the RF signals fed to the antenna 6. The control system 12 is usually a microcomputer with a memory and a program control. The demodulator 10 is coupled to reconstruction means 14, for example a computer, for transformation of the received signals into images that can be made visible, for example, on a visual display unit 15. For the practical implementation of the invention, the MR device 1 comprises a programming for executing an MRI PROPELLER scheme in the above-described manner.

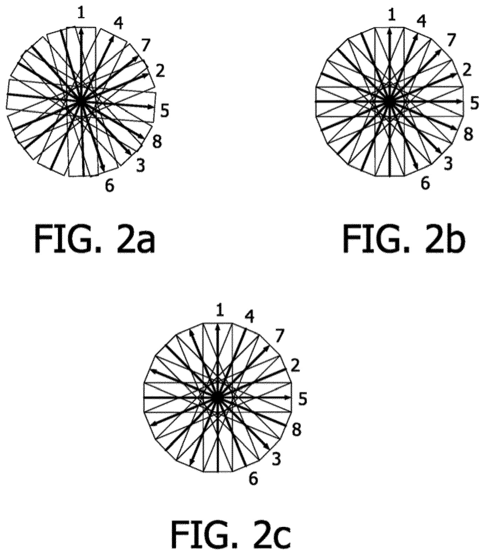

Fig. 2 illustrates the k-space sampling of PROPELLER MRI according to the invention. Eight k-space PROPELLER blades are acquired. The blades are rotated about the center of k-space, so that the total acquired MR data set approximately spans a circle in k-space. The arrows shown in Fig. 2 indicate the directions of the readout magnetic field gradients generated for the respective k-space blades. In Fig. 2a, the rotation angle of the successively acquired k-space blades is incremented by the half Golden angle, which is approximately 68,75°. An isotropic, increasingly dense angular coverage of the circle is achieved in this way, which is also used e.g. by nature for the arrangement of leaves on a plant. The Golden Angle increment generates the interleaved arrangement of successive PROPELLER blades shown in Fig. 2a. As a result, motion-corrupted k-space blades are distributed uniformly over the circle spanned by the PROPELLER acquisition. Image artifacts are reduced as compared to conventional PROPELLER imaging, in which a linear order of consecutive k-space blades is applied. For the diametric PROPELLER blades, only a semicircle of rotation has to be considered. For this reason, the rotation angle increment can be the half Golden Angle instead of the full Golden Angle. The (half) Golden Angle increment results in an infinite sequence period and in a correspondingly asymmetric arrangement of the PROPELLER blades in k-space as can be seen in Fig. 2a. However, in a typical PROPELLER acquisition, the number of k-space blades is fixed. In order to achieve a symmetric arrangement of k-space blades, the Golden Angle blade order shown in Fig. 2a can simply be assigned to a symmetric order as shown in Fig. 2b. Here, the rotation angle of the *i*-th acquired k-space blade is determined by the formula *ϕ*(*i*) = *f*(*i*)·180° / *N*, wherein *f*(*i*) represents a function that maps the index *i* to an integral number between 0 and *N* - 1 such that the desired order is obtained. For the depicted embodiment *f*(*i*) can be tabulated as follows:

| | | | | | | | | |
|---|---|---|---|---|---|---|---|---|
| *i* | 1 | 2 | 3 | 4 | 5 | 6 | 7 | 8 |
| *f*(*i*) | 0 | 3 | 6 | 1 | 4 | 7 | 2 | 5 |

As illustrated by the arrows in Fig. 2b, the readout gradient rotates about 180° during one acquisition in this case. The blade order shown in Fig. 2c is determined by the slightly modified formula *ϕ*(*i*) = *f*(*i*)·*180°*·(*1* + *1* / *N*). In this case, the readout gradient rotates about 360° during each acquisition.

## Claims

1. Device for MR imaging of a body (7) placed in an examination volume, the device (1) comprising
means (2) for establishing a substantially homogeneous main magnetic field in the examination volume,
means (3, 4, 5) for generating switched magnetic field gradients superimposed upon the main magnetic field,
means (6) for radiating RF pulses towards the body (7),
control means (12) for controlling the generation of the magnetic field gradients and the RF pulses,
means (10) for receiving and sampling MR signals, and
reconstruction means (14) for forming MR images from the signal samples, the device (1) being arranged to
a) generate a series of MR signals by subjecting at least a portion of the body (7) to an MR imaging sequence of at least one RF pulse and switched magnetic field gradients,
b) acquire a plurality of k-space blades according to the PROPELLER scheme, the k-space blades being rotated about a center of k-space, wherein the rotation angle of consecutively acquired k-space blades is incremented during MR signal acquisition by an angle being approximately equal to the golden angle of 137,51° or to the half golden angle of 68,75°, and
c) reconstruct an MR image from the acquired MR signals.

2. Device of claim 1, wherein the device (1) is further arranged to select the rotation angle according to the formula *ϕ*(*i*) = *f*(*i*)·180° / *N* or *ϕ*(*i*) = *f*(*i*)*·180°*·(*1* + *1* / *N*), wherein *i* = 1,2,...*N* represents an index of the consecutively acquired k-space blades, and *f*(*i*) represents a function that maps the index *i* to an integral number between 0 and *N* - 1 such that the rotation angle increment *ϕ*(*i* + 1)-*ϕ*(*i*) is approximately equal to the golden angle of 137,51° or to the half golden angle of 68,75° and larger than 180° / *N*.

3. Method for MR imaging of at least a portion of a body placed in an examination volume of an MR device, the method comprising the following steps:
a) generating a series of MR signals by subjecting at least a portion of the body to an MR imaging sequence of at least one RF pulse and switched magnetic field gradients,
b) acquiring a plurality of k-space blades according to the PROPELLER scheme, the k-space blades being rotated about a center of k-space, wherein the rotation angle of consecutively acquired k-space blades is incremented during MR signal acquisition by an angle being approximately equal to the golden angle of 137,51° or to the half golden angle of 68,75°, and
c) reconstructing an MR image from the acquired MR signals.

4. Computer program for an MR device, the program comprising instructions for controlling the MR device such that the method of claim 3 is carried out.

## Patentansprüche

1. Vorrichtung zur MR-Bildgebung eines in einem Untersuchungsvolumen angeordneten Körpers (7), wobei die Vorrichtung (1) umfasst
Mittel (2) zum Ausbilden eines im Wesentlichen homogenen Hauptmagnetfeldes im Untersuchungsvolumen,
Mittel (3, 4, 5) zum Erzeugen geschalteter Magnetfeldgradienten, die dem Hauptmagnetfeld überlagert sind,
Mittel (6) zum Abstrahlen von RF-Pulsen in Richtung des Körpers (7),
Steuerungsmittel (12) zur Steuerung der Erzeugung der Magnetfeldgradienten und der RF-Pulse,
Mittel (10) zum Empfangen und Abtasten von MR-Signalen, und
Rekonstruktionsmittel (14) zur Bildung von MR-Bildern aus den Signalabtastungen,
wobei die Vorrichtung (1) dazu eingerichtet ist
a) eine Reihe von MR-Signalen durch Beaufschlagen mindestens eines Teils des Körpers (7) mit einer MR-Bildgebungssequenz aus mindestens einem RF-Puls und geschalteten Magnetfeldgradienten zu erzeugen,
b) eine Vielzahl von k-Raum-Blades gemäß dem PROPELLER-Schema zu erfassen, wobei die k-Raum-Blades um ein Zentrum eines k-Raums rotiert werden, wobei der Rotationswinkel von aufeinanderfolgend erfassten k-Raum-Blades während der MR-Signalerfassung um einen Winkel erhöht wird, der ungefähr gleich dem goldenen Winkel von 137,51° oder dem halben goldenen Winkel von 68,75° ist, und
c) ein MR-Bild aus den erfassten MR-Signalen zu rekonstruieren.

2. Vorrichtung nach Anspruch 1, wobei die Vorrichtung (1) weiter dazu eingerichtet ist, den Rotationswinkel gemäß der Formel *ϕ*(*i*) = *f*(*i*)·180°/*N* oder *ϕ*(*i*) = *f*(*i*)·180°·(1 + 1/N) zu wählen, wobei *i* = 1,2,...*N* einen Index der aufeinanderfolgend erfassten k-Raum-Blades repräsentiert, und *f*(*i*) eine Funktion repräsentiert, die den Index *i* auf eine ganze Zahl zwischen 0 und *N* - 1 so abbildet, dass das Rotationswinkelinkrement *ϕ*(*i* + 1) - *ϕ*(*i*) ungefähr gleich dem goldenen Winkel von 137,51° oder dem halben goldenen Winkel von 68,75° und größer als 180°/*N* ist.

3. Verfahren zur MR-Bildgebung mindestens eines Teils eines in einem Untersuchungsvolumen einer MR-Vorrichtung angeordneten Körpers, wobei das Verfahren die folgenden Schritte umfasst:
a) Erzeugen einer Reihe von MR-Signalen durch Beaufschlagen mindestens eines Teils des Körpers mit einer MR-Bildgebungssequenz aus mindestens einem RF-Puls und geschalteten Magnetfeldgradienten,
b) Erfassen einer Vielzahl von k-Raum-Blades gemäß dem PROPELLER-Schema, wobei die k-Raum-Blades um ein Zentrum eines k-Raums rotiert werden, wobei der Rotationswinkel von aufeinanderfolgend erfassten k-Raum-Blades während der MR-Signalerfassung um einen Winkel erhöht wird, der ungefähr gleich dem goldenen Winkel von 137,51° oder dem halben goldenen Winkel von 68,75° ist, und
c) Rekonstruieren eines MR-Bildes aus den erfassten MR-Signalen.

4. Computerprogramm für eine MR-Vorrichtung, wobei das Programm Anweisungen zur Steuerung der MR-Vorrichtung umfasst, sodass das Verfahren nach Anspruch 3 ausgeführt wird.

## Revendications

1. Dispositif pour imagerie par résonance magnétique IRM d'un corps (7) placé dans un volume d'examen, le dispositif (1) comprenant
un moyen (2) pour établir un champ magnétique principal sensiblement homogène dans le volume d'examen,
un moyen (3, 4, 5) pour générer des gradients de champ magnétique commutés superposés sur le champ magnétique principal,
un moyen (6) pour émettre des impulsions RF vers le corps (7),
un moyen de commande (12) pour commander la génération des gradients de champ magnétique et des impulsions RF,
un moyen (10) pour recevoir et échantillonner des signaux IRM, et
un moyen de reconstruction (14) pour former des images IRM à partir des échantillons de signal,
le dispositif (1) étant agencé pour
a) générer une série de signaux IRM en soumettant au moins une portion du corps (7) à une séquence d'imagerie IRM d'au moins une impulsion RF et de gradients de champ magnétique commutés,
b) acquérir une pluralité de lames d'espace des k selon le système PROPELLER, les lames d'espace des k étant tournées autour d'un centre de l'espace des k, dans lequel l'angle de rotation de lames d'espace des k acquises de manière consécutive est incrémenté pendant l'acquisition de signal IRM par un angle approximativement égal à l'angle d'or de 137,51° ou à la moitié de l'angle d'or de 68,75°, et
c) reconstruire une image IRM à partir des signaux IRM acquis.

2. Dispositif selon la revendication 1, dans lequel le dispositif (1) est en outre agencé pour sélectionner l'angle de rotation selon la formule *ϕ*(*i*) = *f*(*i*)·180°/*N* ou *ϕ(i)* = *f(i)·180°*·(*1*+*1*/*N*) dans laquelle *i* = 1,2, ..., *N* représente un indice des lames d'espace des k acquises de manière consécutive, et *f*(*i*) représente une fonction qui met en correspondance l'indice *i* avec un nombre entier entre 0 et *N*-1 de sorte que l'incrément d'angle de rotation *ϕ*(*i*+*1*)*-ϕ*(*i*) est approximativement égal à l'angle d'or de 137,51° ou à la moitié de l'angle d'or de 68,75° et plus grand que 180°/*N*.

3. Procédé pour l'imagerie IRM d'au moins une portion d'un corps placé dans un volume d'examen d'un dispositif IRM, le procédé comprenant les étapes suivantes :
a) génération d'une série de signaux IRM en soumettant au moins une portion du corps à une séquence d'imagerie IRM d'au moins une impulsion RF et de gradients de champ magnétique commutés,
b) acquisition d'une pluralité de lames d'espace des k selon le système PROPELLER, les lames d'espace des k étant tournées autour d'un centre de l'espace des k, dans lequel l'angle de rotation de lames d'espace des k acquises de manière consécutive est incrémenté pendant l'acquisition de signal IRM par un angle approximativement égal à l'angle d'or de 137,51° ou à la moitié de l'angle d'or de 68,75°, et
c) reconstruction d'une image IRM à partir des signaux IRM acquis.

4. Programme informatique pour un dispositif IRM, le programme comprenant des instructions pour commander le dispositif IRM de sorte que le procédé de la revendication 3 est effectué.
